(19) Europäisches Patentamt
European Patent Office
Office européen des brevets

(11) EP 0 324 493 B1

(12) **EUROPEAN PATENT SPECIFICATION**

(45) Date of publication and mention
of the grant of the patent:
**13.11.1996  Bulletin 1996/46**

(51) Int Cl.⁶: **G03F 7/00**, G02B 6/00

(21) Application number: **89100520.9**

(22) Date of filing: **13.01.1989**

(54) **Optical waveguide devices, elements for making the devices and methods of making the devices and elements**

Optische Wellenleiter, Elemente für die Herstellung dieser Vorrichtungen und Herstellungsverfahren für diese Elemente und Vorrichtungen

Guide pour ondes optiques, éléments pour la fabrication de ces dispositifs et méthode pour la fabrication de ces dispositifs et éléments

(84) Designated Contracting States:
**AT BE CH DE FR GB IT LI NL SE**

(30) Priority: **15.01.1988 US 144003**

(43) Date of publication of application:
**19.07.1989  Bulletin 1989/29**

(73) Proprietor: **E.I. DU PONT DE NEMOURS AND COMPANY**
**Wilmington Delaware 19898 (US)**

(72) Inventors:
• **Booth, Bruce Lee**
**West Chester Pennsylvania 19382 (US)**

• **Marchegiano, Joseph Emidio**
**Landenberg Pennsylvania 19350 (US)**

(74) Representative: **Abitz, Walter, Dr.-Ing. et al**
**Patentanwälte Abitz & Partner**
**Postfach 86 01 09**
**81628 München (DE)**

(56) References cited:
**DE-A- 2 553 924**       **GB-A- 2 191 603**
**LU-A- 0 065 581**       **US-A- 3 809 732**

**Description**

BACKGROUND OF THE INVENTION

1. Field of the Invention

This invention relates to optical waveguide devices, elements for making the devices and methods of making the devices and elements. The devices are for interconnecting optical fibers, optical components and modules and for use in integrated optical systems.

2. Description of the Prior Art

In optical communication systems, messages are transmitted by carrier waves of optical frequencies that are generated by sources such as lasers or light-emitting diodes. There is much current interest in such optical communication systems because they offer several advantages over conventional communication systems, such as having a greatly increased number of channels of communication and the ability to use other materials besides expensive copper cables for transmitting messages. One such means for conducting or guiding waves of optical frequencies from one point to another is called an optical waveguide. The operation of an optical waveguide is based on the fact that when a medium which is transparent to light is surrounded or otherwise bounded by another medium having a lower refractive index, light introduced along the inner medium's axis is highly reflected at the boundary with the surrounding medium, thus, producing a guiding effect. The most frequently used material for such a waveguide device is glass, which is formed into a fiber of specified dimensions.

As the development of optical circuits proceeded, it became necessary to have devices which could couple, divide, switch and modulate the optical waves from one waveguide fiber to another.

Some optical fibers are interconnected by other optical fibers cut to length. These devices have only two terminals -- one at each end. Photohardened films containing a waveguide have been proposed for this use, such as in U.S. Patent No. 3,809,732. However, the device disclosed therein isn't easily coupled to and aligned with an optical fiber. Further, due to the uneven surface of its film, one cannot easily protect its exposed surface from the environment.

Another method used to form an optical coupling device involves the application of standard photolithographic processes and diffusion. By this prior art process, standard lithographic processes are used to define a pattern in a photoresist layer deposited on a chosen substrate. Then, an etchant is applied to etch the photoresist-defined pattern into the substrate. Next, a metal is deposited in the etched region by vacuum deposition. The photoresist pattern is then lifted off with an appropriate solvent, carrying with it unwanted metal deposits. The structure is then heated to diffuse the metal deposited in the etched region into the substrate, to form a waveguiding layer therein. See, for instance, U.S. Patent No. 4,609,252. In addition to the fact that many steps are involved in such a process, there is also a limitation on the thickness of the metal which may be deposited. First, since vacuum deposition is a relatively slow process, there is the limitation of the excessive amount of time required to deposit a thick layer of metal. Secondly, as more and more metal is deposited, new centers for deposition are created, resulting in an uneven deposit.

To form branches, two or more fibers have been bonded to a common optical port using an adhesive having an index of refraction closely matched to that of the fibers. The fibers are very small in diameter and must be handled with extreme care, bundled together for strength, and attached to a support at intervals. Fabrication of the equivalent of a printed circuit board comprised of these discrete fibers and optical devices is labor-intensive, expensive, slow and tedious, and not readily adapted to automated fabrication techniques. Another method used to form such a coupler is to fuse or melt fibers together so that light from one fiber can pass to the connected fibers. However, in such a fusion process it is difficult to control the extent of fusion and the exact geometry and reproducability of the final structure.

A device of particular interest is the "Y-coupler", which is a "y"-shaped device that couples signals together or divides them apart. "Y"-shaped devices have been made in a wet process by exposing a liquid photoactive layer to ultraviolet radiation through a mask. Then a solvent is used to remove the unpolymerized portions of the layer. See, for instance, U.S. Patent No. 4,609,252. The waveguide of this device, like those mentioned above, isn't protected from the environment or readily coupled to an optical fiber. Further, being a wet process, it has the tendency of being messy and the problem of disposing of the spent solvent.

Another "Y"-shaped coupler device is disclosed in U.S. Patent No. 4,666,236. It further discloses a device with one input branch and three output branches. These devices are also made by a wet process exposing a liquid photopolymer film to light to create a waveguide. The unexposed liquid film is dried and becomes part of the device. The film is further coated with a layer, such as an acrylic resin, to prevent deposition of dust and staining. Again, this process is wet and, thus, inherently messy.

U.S. Patent No. 3,809,686 shows waveguides created in a single photopolymer film by focusing a beam of light within the film and moving the film. It shows multiple waveguides in a single film. In one embodiment, the waveguides exhibit evanescent coupling of light between the waveguides. It further teaches the creation and use of holographic diffraction gratings as light couplers. However, it is difficult to focus light within a film to form a homogenous waveguide with clear and distinct boundaries.

GB-A-2 191 603 discloses a method of making an optical waveguide device with at least one buried channel waveguide in a laminate wherein a three-layer sandwich board is provided of which the middle layer is made of a material, e.g. polycarbonate, which has a refractive index that increases when it is exposed to a light beam. The optical waveguide is formed by moving the light beam relative to the board to trace the required path of the optical conductor. The middle layer can be irradiated before it is sandwiched between the other two layers or afterwards.

## SUMMARY OF THE INVENTION

The invention is directed to the problem of providing an optical waveguide device which is easily coupled to and aligned with an optical fiber and a method of making such an optical waveguide device.

That problem is solved by the method of claim 1 and the optical waveguide device of claim 28.

The invention is further directed to a system for transmitting light comprising such an optical waveguide device and to an optical waveguide element for use in forming optical devices.

Preferred embodiments of the invention are set forth in the subclaims.

## BRIEF DESCRIPTION OF THE DRAWINGS

The invention may be more fully understood from the following detailed description thereof taken in connection with accompanying drawings which form a part of this application and in which:

Figure 1 is a perspective view of a photohardenable film removably adhered to a support.

Figure 2a is a schematic representation of a first embodiment for forming an optical waveguide element comprising a waveguide in a film on a support.

Figure 2b is a schematic representation of a second embodiment for forming an optical waveguide element comprising a waveguide in a film on a support.

Figure 2c is a schematic representation of a third embodiment for forming an optical waveguide element comprising a waveguide in a film on a support.

Figure 3 depicts an optional step of flooding the film having a waveguide on a support with light resulting in an element.

Figure 4 shows a laminated element comprising from top to bottom a support, a photohardenable layer, a film having a waveguide, and another support.

Figure 5 illustrates an optional step of flooding the element of Figure 4 with light.

Figure 6 is the element of Figure 4 or 5 with one of the supports removed.

Figure 7 is a perspective view of an optical waveguide element comprising from top to bottom a support, a photohardenable or photohardened layer, a film having a waveguide, a photohardenable layer, and a support.

Figure 8 shows the step of hardening the element of Figure 7 by flooding it with light.

Figure 9 shows the step of hardening the element of Figure 7 or the device of Figure 8 by heating it.

Figure 10 is a perspective view of an optical waveguide device for use in integrated optical systems, the device comprising from top to bottom a first hardened layer, a hardened film having a waveguide, and a second hardened layer.

Figure 11 shows the step of stabilizing the element of Figure 10 by heating it.

Figure 12 shows a buried channel waveguide device coupled to an optical fiber with light being injected through the fiber and waveguide.

Figure 13a illustrate directing coherent light within the element of Figure 4 to produce a holographic diffraction grating.

Figure 13b is a cross sectional representation of a holographically formed grating coupling light to a waveguide buried between layers.

Figure 14 is a cross sectional view of a laminated device having a film, multiple layers, an end support, waveguides and a grating.

## DESCRIPTION OF THE PREFERRED EMBODIMENTS

Throughout the following detailed description, similar reference numerals refer to similar elements in all Figures of the drawings.

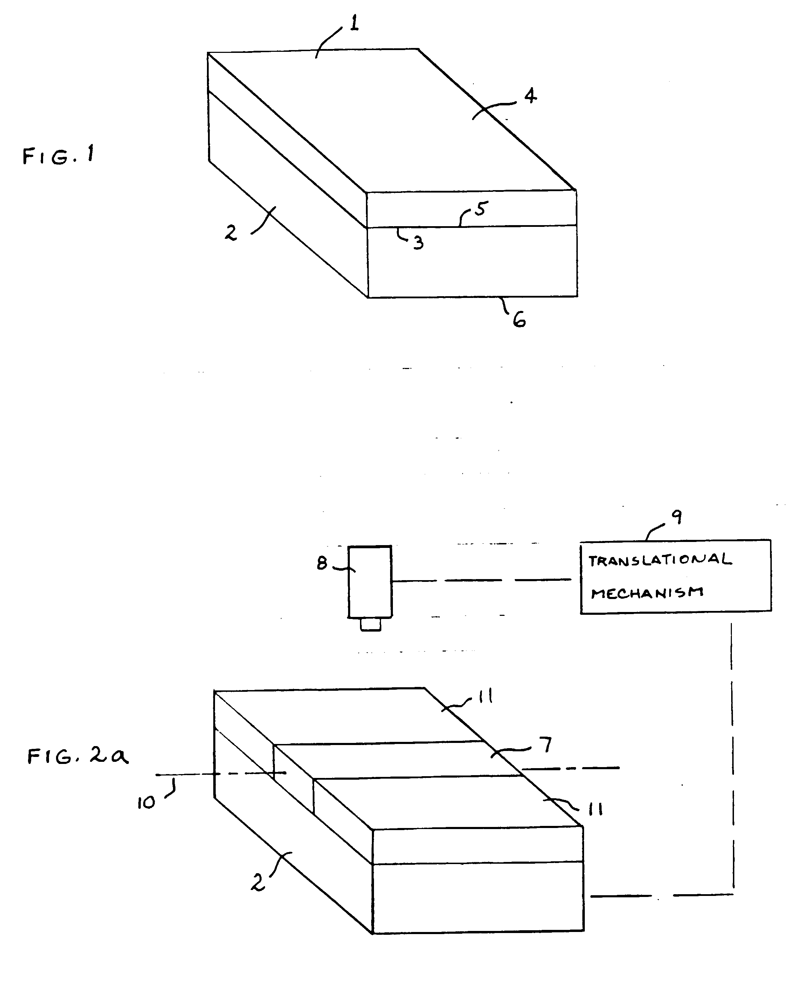

Referring to Figure 1, an element used in the method of the present invention is illustrated comprising a substantially dry photohardenable film 1 removably adhered to a support 2. The film 1 has a first surface 3 and a second surface 4. The support similarly has a first surface 5 and a second surface 6. The first surface 5 of the support 2 is removably adhered to the first surface 3 of the film 1. In a preferred embodiment, the surfaces 3, 4, 5 and 6 of the film 1 and the support 2 are substantially flat.

The film 1 may have a thickness in the range of 2 micrometers through 15 micrometers or above, preferably in the range of 4.5 micrometers through 8.0 micrometers, and more preferably about 5.3 micrometers.

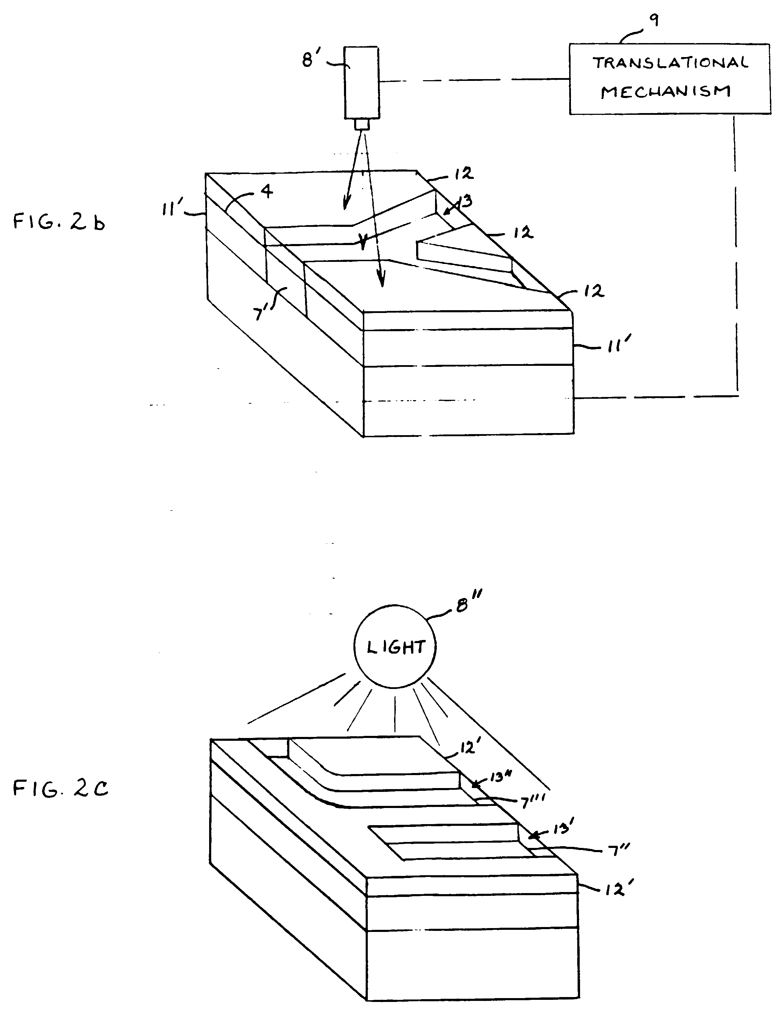

The first step of the method of the present invention comprises exposing to light at least a first region 7 of the film 1 polymerizing at least one monomer in the film 1 and changing the refractive index of the region 7 to form at least a first optical waveguide. The term waveguide is defined by those skilled in this art to include the entire area that transmits radiant energy. This technically includes some area just around the exposed region. However, for simplicity, the exposed region can be considered to substantially be the waveguide. In theory, the waveguide formation is believed to be due to a self-focusing property of the film material. Upon exposure to light, a polymerization reaction is induced in the exposed region. It is believed that there is interdiffusion between the exposed and unexposed regions, at least near the interface of these regions. This interdiffusion changes and typically increases the density of the exposed region raising its refractive index creating a lens-like exposed region directing the light in a self focused fashion to create a narrow smooth walled waveguide of approximately the same dimension as the mask area or light beam width. Three embodiments for performing this first step are illustrated in Figures 2a, 2b and 2c.

In Figure 2a, a focused laser light source 8 exposes the region 7 to form the waveguide. A translational mechanism 9 is connected to the laser light source 8 and/or the support 2 for moving the laser light source 8, the support 2 or both, to create the waveguide having a desired and/or predetermined pattern. Here, the exposed region 7 has a substantially elongated box configuration having an optical axis 10 through the longitudinal center of the region 7. A physical cross section of the exposed region 7 perpendicular to the optical axis 10 is substantially rectangular. On both sides of the region 7 are remaining unexposed regions 11 of the film 1.

Figure 2b shows an alternate embodiment for exposing a region 7′. Here, a non-focused laser light source 8′ is generally directing actinic radiation toward the element of Figure 1. An opaque mask 12 is positioned between the laser light source 8′ and the film 1, typically contacting and covering the second film surface 4. The mask 12 has at least a patterned area 13 therein though which actinic radiation from the light source 8′ exposes region 7′. The patterned area can have any desired configuration, including the substantially Y configuration shown in Figure 2b. Exposing the region 7′ through this area 13 results in the creation of a waveguide having a substantially Y configuration. Described more generically, the region can have one end adapted to inlet or outlet light connected to a plurality of ends (e.g., 2, 3, 4...) adapted to inlet or outlet light. As in the Figure 2a embodiment, there are remaining unexposed regions 11′ in the film 1.

A third embodiment for performing the exposing step of the present method is illustrated in Figure 2c. Here, actinic radiation from a light source 8″ exposes a first region 7″ and a second region 7‴ of the film 1 through an opaque mask 12′. This mask 12′ has first and second areas 13′ and 13″ for the light to pass through exposing regions 7″ and 7‴, respectively. The second area 13″ approaches and is in part parallel to the first area 13′. Thus, after exposure, the exposed second region 7‴ and the corresponding waveguide approaches and is in part parallel to the exposed first region 7″ and the corresponding waveguide. As a result, the waveguides can be positioned to exhibit evanescent coupling of light injected into one of the waveguides by gradually leaking or coupling the injected light into the other waveguide.

In each of these preferred embodiments, after exposure, the first and second surfaces 3 and 4 of the film 1 remain substantially flat. This facilitates subsequent laminating of layers on the film surfaces. As such, Figures 2a, 2b and 2c illustrate the making of optical waveguide elements in accordance with this invention useful in making optical waveguide devices which in turn are useful in integrated optical systems.

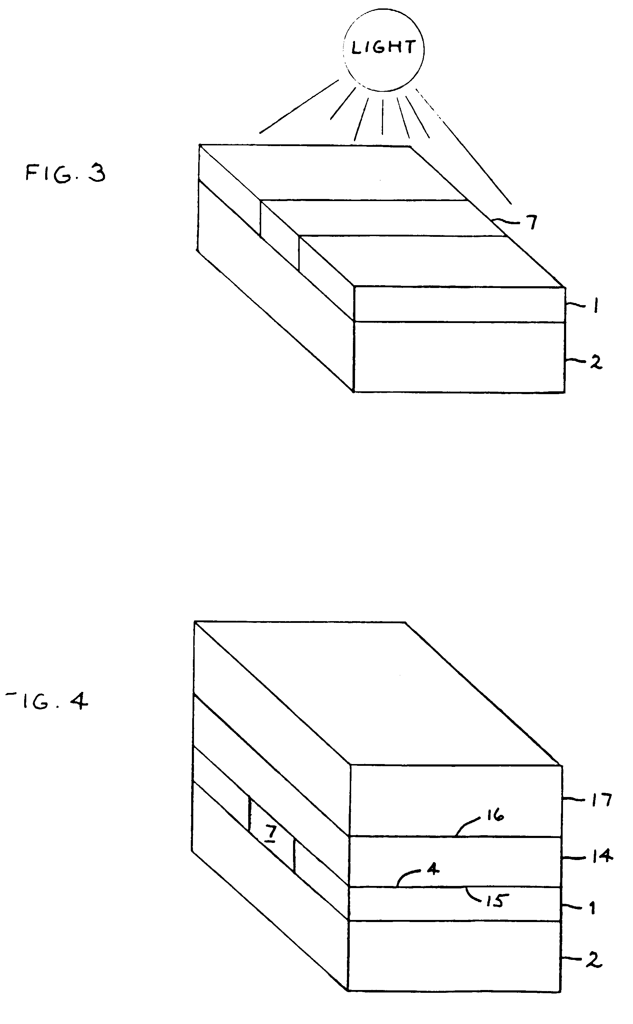

Figure 3 illustrates an optional step which follows the exposing step. The element resulting from the exposure step can be flooded with light, such as broadband ultraviolet light. This polymerizes some of at least one monomer in the film and typically most or all of one or all of the monomers in the film. This may allow for easy removal or attachment of the support 2. This resulting optical waveguide element can similarly be used in making optical waveguide devices in accordance with the method of this invention.

Next, referring to Figure 4, a first substantially dry photohardenable layer 14 is laminated to the second film surface 4. The first layer 14 has first and second surfaces 15 and 16, respectively. The first layer 14 first surface 15 is laminated to the second film surface 4 by placing them in intimate contact and controllably applying pressure with rollers to remove air between the film 1 and layer 14. The first layer 14 is tacky. It the optional flooding step illustrated in Figure 3 is not performed, then the film 1 is also tacky. Thus, the film 1 and first layer 14 easily adhere to one another. A support 17 is removably adhered to the second surface 16 of the first layer 14. Figure 4 illustrates another optical waveguide element in accordance with the present invention useful in making optical waveguide devices.

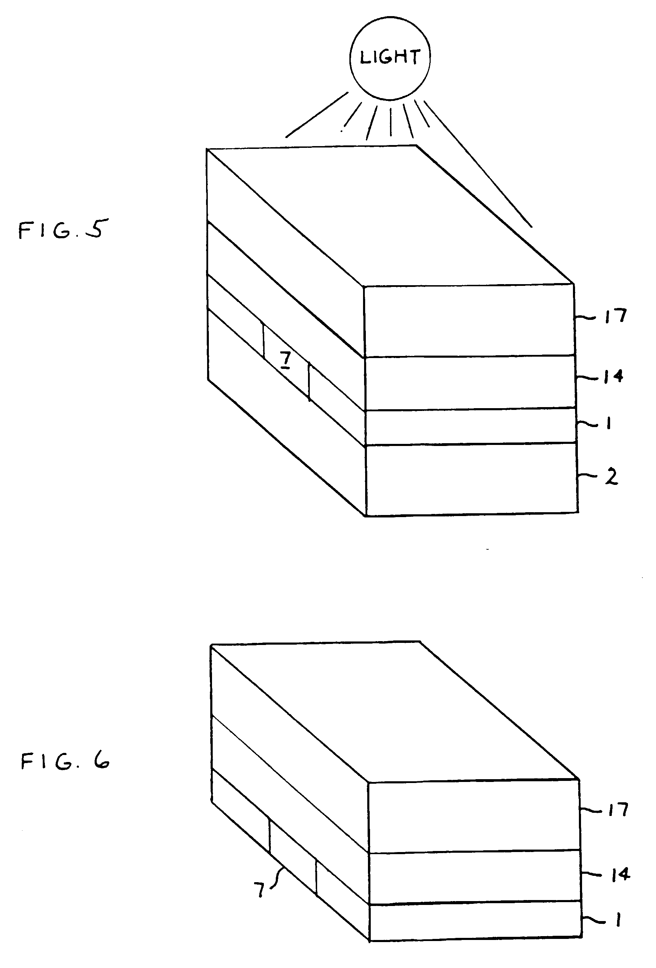

Figure 5 shows an optional flooding step similar to that illustrated in Figure 3, except the element being flooded is modified as described in relation to Figure 4. The element resulting from the first laminating step can be flooded with light, such as broadband ultraviolet light. This polymerizes some of at least one monomer (and typically most or all of one or all of the monomers) in the first layer 14 and further polymerizes some of the at least one monomer in the film 1 (if not already polymerized by a previous flooding step). Extensive crosslinking or polymerization occurs between the monomer(s) of the layer 14 adjacent to the monomer(s) of the film 1 forming a diffuse boundary line or region. The resulting optical waveguide element is also useful in making an optical waveguide device in accordance with this invention.

Figure 6 shows the element after the next step of removing the support 2 from the film 1 first surface 3.

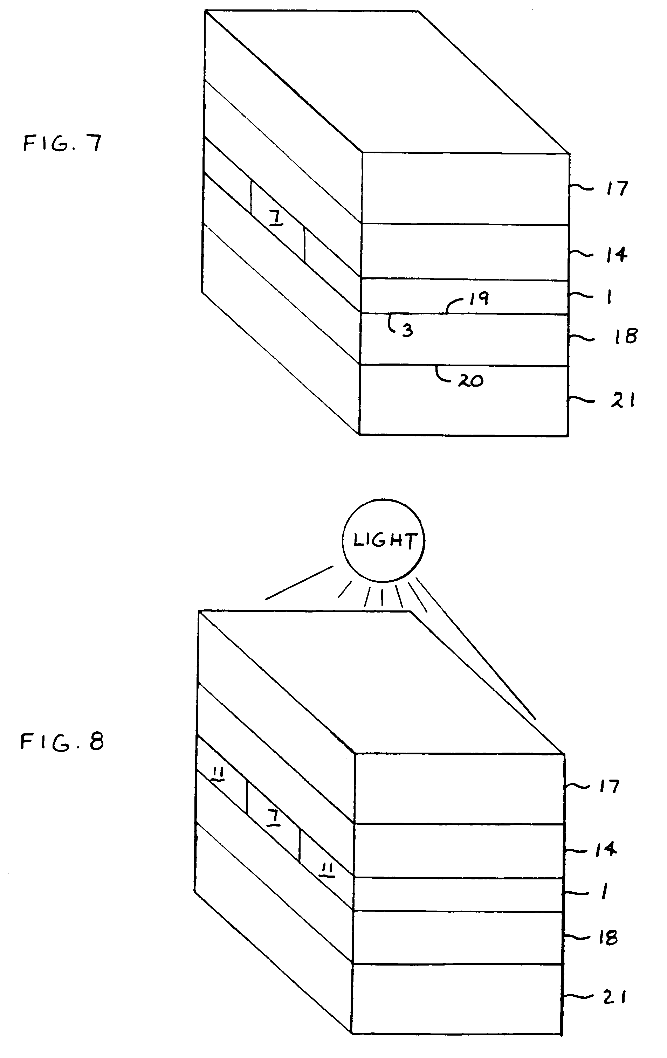

Then, referring to Figure 7, a second substantially dry photohardenable layer 18 is laminated to the film 1 first surface 3. The second layer 18 has first and second surfaces 19 and 20, respectively. The second layer 18 first surface 19 is laminated to the film first surface 3 by placing them in intimate contact and controllably applying pressure with rollers removing air between the film 1 and the second layer 8. The second layer surfaces 19 and 20 are tacky and, thus, easily adhere to the film 1. A support 21 is removably adhered to the second layer second surface 20. Another optical waveguide element results which is useful in making optical waveguide devices.

Figure 8 illustrates a step of hardening the element depicted in Figure 7 by flooding it with light, such as broadband ultraviolet light.

Throughout this application, the term "broadband ultraviolet light" means light in the spectral region of about 350 through 400 nanometers. This step occurs for minutes, preferably 5, but can last longer. If this is the first flooding step, then this is the first polymerization of at least one monomer (and typically most or all of one or all monomers) in the remaining regions 11 in the film 1 and the first and second layers 14 and 18, respectively. It further polymerizes the at least one monomer in the region 7 of the film 1. If this is not the first flooding step, it polymerizes at least one monomer in the second layer and continues polymerizing the at least one monomer in the rest of the element. Some crosslinking or polymerization occurs between the previously polymerized film 1 and the monomer(s) in the second layer 18 forming a boundary line or region that is more evident than if the film 1 had not previously been flooded with light. A device results having at least one buried channel waveguide in a laminated and photohardened matrix useful in integrated optical systems.

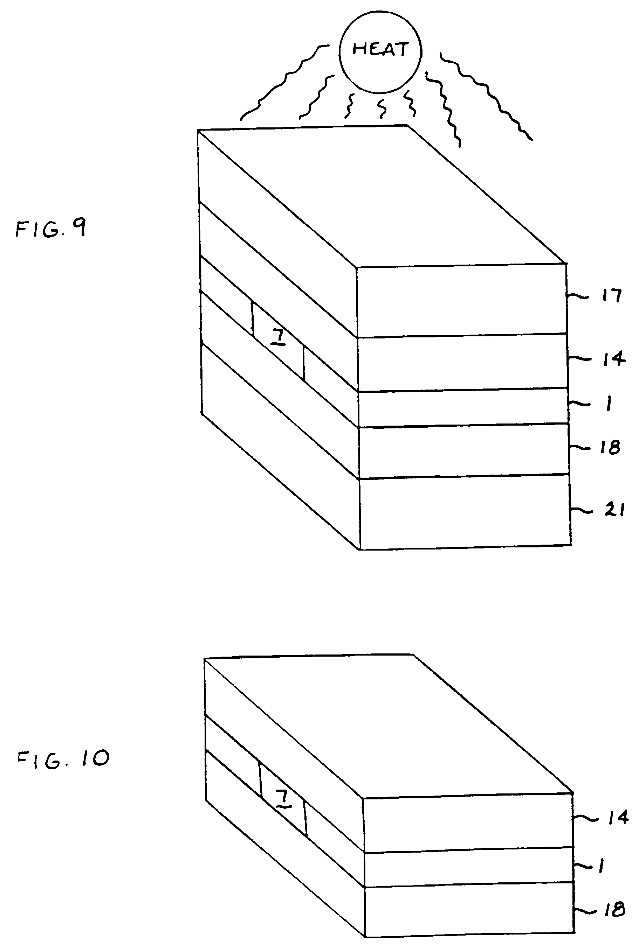

Figure 9 illustrates another possible step of hardening the element depicted in Figure 7 by heating it. Actually, the layers and film can be heated before, in combination with, after, or in lieu of the light flooding step to harden or further harden the device. This heating step occurs at a temperature in the range of about 50°C through 200°C and preferably in the range of about 100°C through 150°C for a duration of minutes, preferably 5.

Photohardenable compositions are typically less sensitive to temperatures up to 100°C than above 100°C. However, hardening may be initiated as low as 50°C if held at the temperature for a sufficient period of time. As the temperature is increased beyond 100°C, thermally initiated hardening increases significantly.

After the hardening step, a maximum refractive index increase in the localized waveguide region as measured by an ASUJENA Interphako microscope occurs in the film 1 in the range of 0.001 through 0.40 measured at 546 nanometers wavelength. The localized refractive index increase, $\Delta n$, for the purposes of this invention, is derived by conventional shearing interference microscopy techniques and is calculated assuming a uniform index shift through the film such that An is effectively an average using the following equations:

$$f\lambda = \Delta nd$$

$$f = \frac{a}{b}$$

$$\frac{a\lambda}{b} = \Delta nd$$

where

d =    assumed waveguide thickness, typically the film thickness
a =    waveguide fringe shift
b =    fringe spacing
$\lambda$ =    0.546 $\mu$, wavelength of light in the microscope.

This localized refractive index increase is contrasted and is not to be confused with a refractive index modulation measured from gratings prepared holographically,

After the hardening step, the waveguide is transparent in the range of 0.6 through 1.6 micrometers wavelength. It is effectively transparent at 1.3 micrometers for single mode operation.

Also after the hardening step, the maximum refractive index of the matrix except in and near the waveguide is in the range of 1.45 through 1.60 measured at 632 nanometers depending on formulation and/or extent of interlayer diffusion from adjoining layers or film of different indexes. The refractive index is determined by using an ABBE refractometer manufactured by Karl Zeiss.

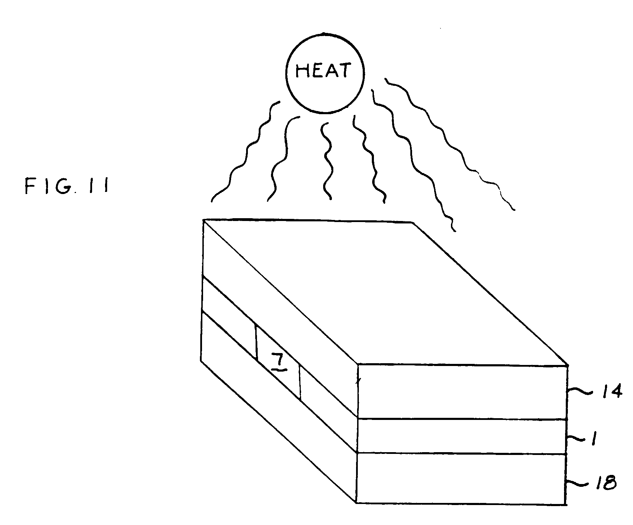

The supports 17 and 21 can be removed from the device resulting from the hardening step as shown in Figure 10.

It has been found that a time delay of 5 to 120 minutes, preferably 20 to 30 minutes, after each flooding step and before removal of support sheets and/or subsequent lamination is desirable to facilitate interlayer diffusion and polymerization.

Figure 11 shows an optional, but preferred, step of stabilizing the device shown in Figure 10 by heating it, typically after the hardening step. This heating step similarly occurs at a temperature in the range of about 50°C through 200°C and preferably in the range of about 100°C through 150°C. However, this stabilizing step occurs longer than the hardening step. Preferably the stabilizing step occurs in the range of about 30 minutes through 2 hours and more preferably for about an hour. This heating makes the device more environmentally stable ensuring water and other elements in the environment will not interfere with proper operation of the device. Further, this heating provides thermal stabilization of optical and mechanical properties allowing operation of the resulting device over a wide range of temperatures without modification of the device properties.

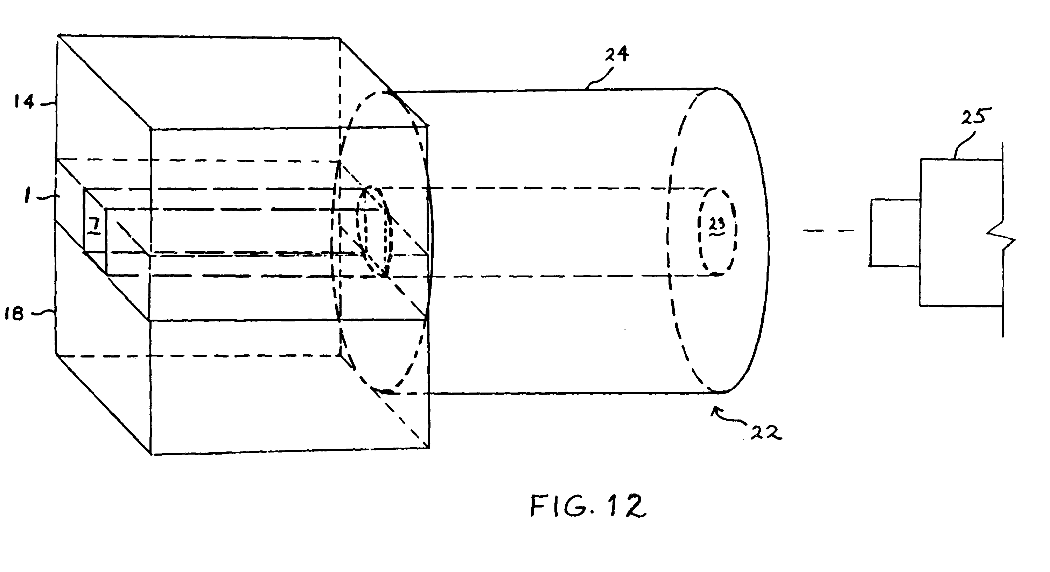

In the device of Figure 10 or 11, the first and second layers 14 and 18, respectively, have equal thicknesses. Further, the remaining regions 11 are equal in size and symetric on either side of region 7. As such, the device has a buried channel waveguide that can be dimensioned to easily couple to virtually any optical fiber. Figure 12 shows the device of either Figure 10 or 11 coupled to an optical fiber 22. The fiber has a cylindrical core 23 and a cylindrical cladding 24 surrounding the core 23. Standard single mode fiber has a cladding diameter of about 125 micrometers and a core diameter of about 7 micrometers. The laminated waveguide device, now clad from above and below, is shown advantageously coupled to the optical fiber 22 simply by abutting the fiber core 23 to the buried waveguide aligning their optical axes. This is accomplished by merely positioning the optical waveguide device adjacent the optical fiber on a flat surface, if the dimensions of the device are preselected for the particular fiber. This aligning can be facilitated by using a film 1 having a thickness which substantially defines one dimension of a substantially rectangular cross section of the waveguide. For coupling to standard single mode fiber, the film thickness should be about 5 to 6 micrometers, preferably 5.3; the exposure width should be about 5 micrometers; and each one of the first and second layers should be about 59.85 micrometers thick. The total matrix thickness can be made any dimension including about 125, 180 and 200 micrometers.

Figure 12 also shows the step of injecting light from a light source 25 into and through the optical fiber 22 and buried waveguide.

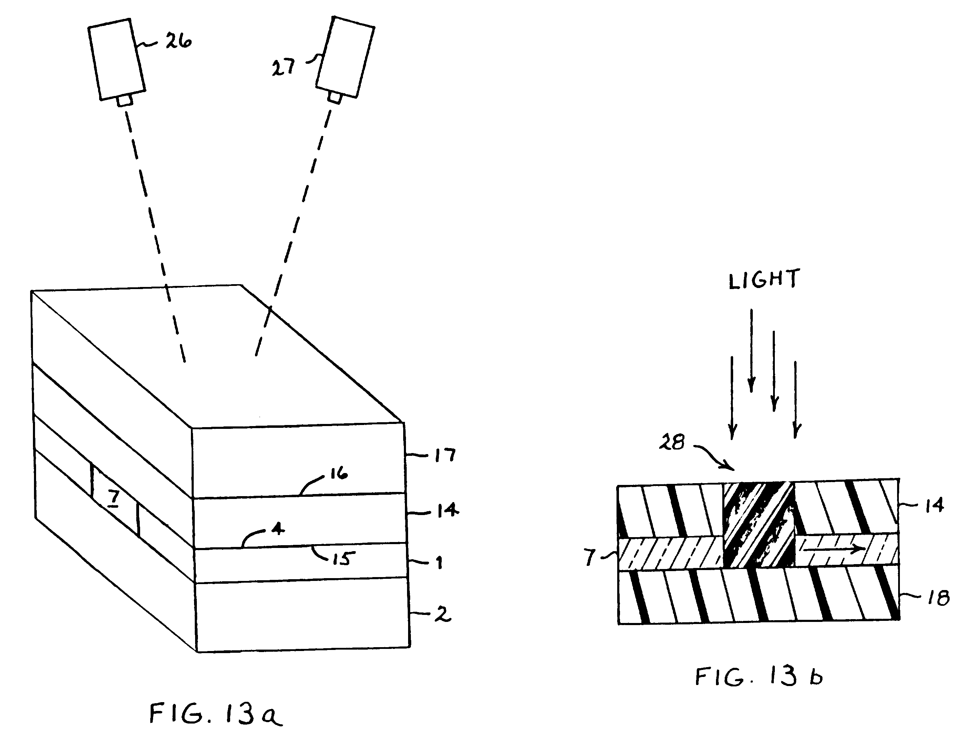

Figure 13a illustrates an optional step of directing at least two coherent light beams, such as from lasers 26 and 27 to intersect in an area within the element of Figure 4. These beams are directed to provide a resultant light intensity that spatially varies in such a way as to produce a holographic diffraction grating 28. The grating comprises regions of varying refractive index for input of light to the waveguide or waveguide portion or output of light from the waveguide or waveguide portion. A grating can direct light to or from a waveguide in the film or to or from one of the layers or from a waveguide or waveguide portion in the film (or one of the layers) to another waveguide or waveguide portion within the film (or the one layer). Further, as well known in the art, gratings can be wavelength selective by only directing one or more predetermined wavelengths. Figure 13b shows a cross section of the Figure 10 or 11 device having the holographic diffraction grating 28 in the first layer 14 and the region 7. The grating 28 can be in areas selected from the group consisting of at least part of the region, at least part of one of the layers near the region, and combinations thereof, provided that there has been no previous hardening step for the film and/or layer in which the grating is to be constructed. Further, the directing step can be accomplished at other stages of development of the device described herein.

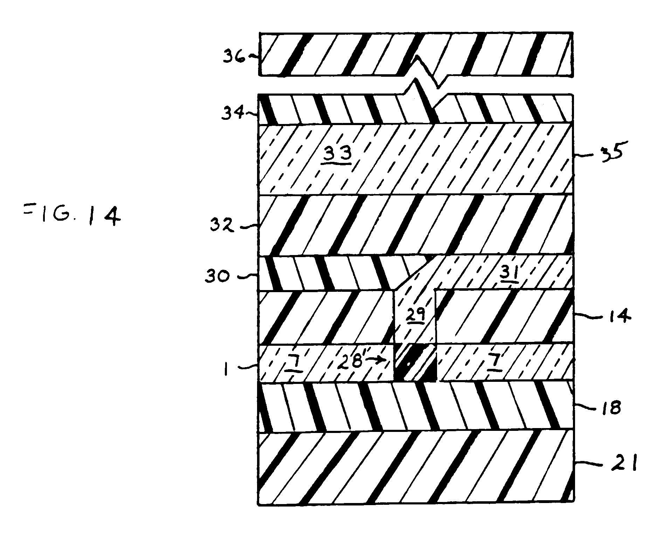

One of the advantages of the present invention is the ease of adding one or more substantially dry photohardenable or photohardened layers with or without a waveguide or grating. This versatility is demonstrated in the device illustrated in Figure 14. This optical waveguide device has exposed regions 7, 29, 31 and 33 in film 1 and layers 14, 30 and 35, respectively. It further shows buffer layers 18, 32, 34 and 36, and a support 21. Region 7 has a holographic diffraction grating to direct light from region 7 to region 29 or the reverse. As an alternative to using a grating to change the direction of light, layer 30 illustrates other techniques, such as one disclosed in U.S. Patent No. 4,472,020, are possible. Further, the break between layers 34 and 36 is intended to show that devices can have as many or few layers as desired. Of course, waveguides in different layers or in the film and a layer could be formed to exhibit evanescent coupling therebetween.

All layers including those designated by the numbers 14, 18, 30, 32, 34, 35 and 36 can be made out of the same material as the film. Then the hardened device matrix is substantially homogenous in composition and refractive index except in and near the waveguide. Preferably, however, after the hardening step, the waveguide has a refractive index about 0.005 to 0.060 greater than the hardened film and about 0.001 to 0.025 greater than the hardened layers. Of course, regardless of whether different materials are used for different layers and the film, the composition and refractive index in each exposed region is substantially homogenous in composition and refractive index.

The photohardenable film and layers used herein are thermoplastic compositions which upon exposure to actinic radiation form crosslinks or polymers of higher molecular weight to change the refractive index and rhelogical character of the composition(s). Preferred photohardenable materials are photopolymerizable compositions, such as disclosed in U.S. Patent 3,658,526. In these materials, free radical addition polymerization and crosslinking of a compound containing one or more ethylenically unsaturated groups, usually in a terminal position, hardens and insolublizes the composition. The sensitivity of the photopolymerizable composition is enhanced by the photoinitiating system which may contain a component which sensitizes the composition to practical radiation sources, e.g., visible light. Conventionally a binder is the most significant component of a substantially dry photopolymerizable film or layer in terms of what physical properties the film or layer will have while being used in the invention. The binder serves as a containing medium for the monomer and photoinitiator prior to exposure, provides the base line refractive index, and after exposure contributes to the physical and refractive index characteristics needed for the refractive index image formed. Cohesion, adhesion, flexibility, diffusibility, tensile strength, in addition to index of refraction are some of the many properties which determine if the binder is suitable for use in a refractive index media.

Dry film or layer photohardenable elements contemplated to be equivalent are photodimerizable or photocrosslinkable compositions such as disclosed in U.S. Patent No. 3,526,504 or those compositions in which hardening is achieved by a mechanism other than the free radical initiated type identified above.

While the photopolymerizable film or layer is a solid sheet of uniform thickness it is composed of three major components, a solid solvent soluble preformed polymeric material, at least one liquid ethylenically unsaturated monomer capable of addition polymerization to produce a polymeric material with a refractive index substantially different from that of the preformed polymeric material, and a photoinitiator system activatable by actinic radiation. Although the film or layer is solid composition, components interdiffuse before, during and after imaging exposure until they are fixed or destroyed by a final uniform treatment usually by a further uniform exposure to actinic radiation. Interdiffusion may be further promoted by incorporation into the composition of an otherwise inactive plasticizer. In addition to the liquid monomer, the composition may contain solid monomer components capable of interdiffusing in the solid composition and reacting with the liquid monomer to form a copolymer with a refractive index shifted from that of either the preformed polymeric material.

In the preferred compositions for use as the film or layers in this invention, the preformed polymeric material and the liquid monomer are selected so that either the preformed polymeric material or the monomer contains one or more moieties taken from the group consisting essentially of substituted or unsubstituted phenyl, phenoxy, naphthyl naphthyloxy and heteroaromatic groups containing one to three aromatic rings and chloro or bromo atoms and wherein the remaining component is substantially free of the specified moieties. In the instance when the monomer contains these moieties, the photopolymerizable system hereinafter is identified as a "Monomer Oriented System" and when the polymeric material contains these moieties, the photopolymerizable system hereinafter is identified as a "Binder Oriented System".

The stable, solid, photopolymerizable compositions preferred for this invention will be more fully described by reference to the "Monomoer Oriented System" and "Binder Oriented System".

## MONOMER ORIENTED SYSTEM

The monomer of the Monomer Oriented System is a liquid, ethylenically unsaturated compound capable of addition polymerization and having a boiling point above 100°C. The monomer contains either a phenyl, phenoxy, naphthyl napthoxy or heteroaromatic group containing one to three aromatic rings or a chloro or bromo atom. The monomer contains at least one such moiety and may contain two or more of the same or different moieties of the group, provided the monomer remains liquid. Contemplated as equivalent to the groups are substituted groups where the substitution may be lower alkyl, alkoxy, hydroxy, carboxy, carbonyl, amino, amido, imido or combinations thereof provided the monomer remains liquid and diffusable in the photopolymerizable layer.

Preferred liquid monomers for use in the Monomer Oriented System of this invention are 2-phenoxyethyl acrylate, 2-phenoxyethyl methacrylate, phenol ethoxylate acrylate, 1-($\rho$-chloro phenoxy) ethyl acrylate, $\rho$-Chlorophenyl acrylate, phenyl acrylate, 1-phenylethyl acrylate, di(2-acryloxyethyl)ether of bisphenol-A, and 2-(2-naphthyloxy)ethyl acrylate.

While monomers useful in this invention are liquids, they may be used in admixture with a second solid monomer of the same type, e.g., N-vinylcarbozle, ethylenically unsaturated carbozole monomers such as disclosed in Journal of Polymer Science: Polymer Chemistry Edition, Vol. 18, pp. 9-18 (1979) by H. Kamogawa et al, 2-naphthyl acrylate, pentachlorophenyl acrylate, 2,4,6-tribromophenyl acrylate, and bisphenol A diacrylate, 2-(2-naphthyloxy)ethyl acrylate, and N-phenyl maleimide.

The solvent soluble polymeric material or binder of the Monomer Oriented System is substantially free of phenyl, phenoxy, naphthyl naphthyloxy or heteroaromatic group containing one to three aromatic rings as well as chloro or bromo atoms.

Preferred binders for use in the Monomer Oriented System of this invention are cellulose acetate butyrate polymers;

acrylic polymers and inter polymers including polymethyl methacrylate, methyl methacrylate/methacrylic acid and methyl methacrylate/acrylic acid copolymers, terpolymers of methylmethacrylate/$C_2$-$C_4$ alkyl acrylate or methacrylate/ acrylic or methacrylic acid; polyvinylacetate; polyvinyl acetal, polyvinyl butyral, polyvinyl formal; and as well as mixtures thereof.

BINDER ORIENTED SYSTEM

The monomer of the Binder Oriented System is a liquid ethylenically unsaturated compound capable of addition polymerization and having a boiling point above 100°C. The monomer is substantially free of moieties taken from the group consisting essentially of phenyl, phenoxy, naphthyl naphthyloxy or heteroaromatic group containing one to three aromatic rings as well as chloro or bromo atoms.

Preferred liquid monomers for use in Binder Oriented Systems of this invention include decanediol diarcrylate, isobornyl acrylate, triethylene glycol diacrylate, diethyleneglycol diacrylate, triethylene glycol dimethacrylate, ethoxyethoxyethyl acrylate, triacrylate ester of ethoxylated trimethylolpropane, and 1-vinyl-2-pyrrolidinone.

While monomers used in Binder Oriented Systems are liquids, they may be used in admixture with a second solid monomer of the same type, e.g., N-vinylcaprolactam.

The solvent soluble polymeric material or binder of the Binder Oriented System contains in its polymeric structure moieties taken from the group consisting essentially of phenyl, phenoxy, naphthyl naphthyloxy or heteroaromatic group containing one to three aromatic rings as well as chloro or bromo atoms. Contemplated as equivalent to the groups are substituted groups where the substitution may be lower alkyl, alkoxy, hydroxy, carboxy, carbonyl, amido, imido or combinations thereof provided the binder remains solvent soluble and thermoplastic. The moieties may form part of the monomeric units which constitute the polymeric binder or may be grafted onto a preprepared polymer or interpolymer. The binder of this type may be a homopolymer or it may be an interpolymer of two or more separate monomeric units wherein at least one of the monomeric units contains one of the moieties identified above.

Preferred binders for use in the Binder Oriented System include polystyrene, poly (styrene/acrylonitrile), poly(styrene/methyl methacrylate), and polyvinyl benzal as well as admixtures thereof.

The same photoinitiator system activatable by actinic radiation may be used in either the Monomer Oriented System or the Binder Oriented system. Typically the photoinitiator system will contain a photoinitiator and a sensitizer which extends the spectral response into regions having special utility, e.g., the near U.V. region and the visible spectral regions where lasers emit.

Preferred photoinitiators include DDM-HABI, i.e., 2-(O-chlorophenyl)-4,5-bis(m-methoxyphenyl)-imidazole dimer; o-Cl-HABI, i.e., 1,1'-Biimidazole, 2,2'-bis(o-chlorophenyl)-4,4', 5,5'-tetraphenyl-; and TCTM-HABI, i.e., 1H-Imidazole, 2,5-bis (o-chlorophenyl)-4- 3,4-dimethoxyphenyl-, dimer each of which is typically used with a hydrogen donor, e.g., 2-Mercapto benzoxazole.

Preferred sensitizers include the following:

DBC, i.e., Chclopentanone, 2,5-bis-4-(diethylamino)-2-methylphenyl-methylene);
DEAW, i.e., Cyclopentanone, 2,5-bis-((4-(diethylamino)-phenyl)methylene); and
Dimethoxy-JDI, i.e., 1H-Inden-1-one, 2,3-dihydro-5,6-dimethoxy-2-((2,3,6,7-tetrahydro-1H,5H-benzo[i,j]quinolizin-9-yl)-methylene)-.

The solid photopolymerizable compositions of this invention may contain a plasticizer. Plasticizers of this invention may be used in amounts varying from about 2% to about 20% by weight of the compositions preferably 5 to 15 wt.%.

Preferred plasticizers for use in simple cellulose acetate butyrate systems are triethyleneglycol dicaprylate, tetraethyleneglycol diheptanoate, diethyl adipate, Brij®30 and tris-(2-ethylhexyl)phosphate. Similarly, triethyleneglycol dicaprylate, diethyl adipate, Brij®30, and tris-(2-ethylhexyl)phosphate are preferred in "Monomer Oriented Systems" where cellulose acetate butyrate is the binder.

Other components in addition to those described above can be present in the photopolymerizable compositions in varying amounts. Such components include: optical brighteners, ultraviolet radiation absorbing material, thermal stabilizers, hydrogen donors, oxygen scavengers and release agents.

Amounts of ingredients in the photopolymerizable compositions will generally be within the following percentage ranges based on total weight of the photopolymerizable layer: monomer, 5-50%, preferably 15-35%; initiator 0.1-10%, preferably 1-5%; binder, 25-75%, preferably 45-65%; plasticizer, 0--25%, preferably 5-15%; other ingredients 0-5%, preferably 1-4%.

The supports can be any substance transparent to actinic radiation that provides sufficient support to handle the combined film 1 and layer 2. Preferably the support 2 is transparent to light in the spectral region of 0.6 through 1.6 micrometers wavelengths. The term "support" is meant to include natural or synthetic supports, preferably one which is capable of existing in a flexible or rigid film or sheet form. For example, the support or substrate could be a sheet or film of synthetic organic resin, or a composite of two or more materials. Specific substrates include polyethylene terephthalate film, e.g., resin-subbed polyethylene terephthalate film, flame or electrostatic discharge treated polyethylene terephthalate film, glass, cellulose acetate film, and the like. The thickness of the supports has no particular importance so long as it adequately supports the film or layer removeably adhered to it. A support thickness of about 25 to 50 micrometers using polyethylene terephthalate provides sufficient rigidity to a film 6 microns thick.

The following example is provided as an illustration of, but does not limit, the invention.

EXAMPLE

A substantially dry photohardenable (active) film of about 5.3 µm thick, having the ingredients listed in Table I, coated on a 25 µm thick clear polyethylene terephthalate support, in approximately a 3 inch X 4 inch section, is exposed to broad band ultraviolet light in the spectral range of 350 to 400 nm through a conventional chrome-plated glass photomask to produce a 1 X 4 (one waveguide end to four waveguide ends or four to one) coupler waveguide pattern. After exposure and then an appropriate delay time of about 15 minutes, the mask is removed.

Next, a first substantially dry photohardenable (buffer) layer of about 30 µm thick, having the ingredients listed in Table II, coated on a 25 µm thick clear polyethylene terephthalate support, is laminated to the film surface over the waveguide pattern as shown in Figure 4. The resultant element is subsequently flooded with broadband ultraviolet light in the spectral range of 350 to 400 nanometers. The film support is then removed by mechanical stripping.

Next, a second photohardenable (buffer) layer of identical composition and structure, as the first buffer layer, with support, is laminated to the opposite surface of the (active) film and flooded as above.

In subsequent steps, the supports attached to the buffer layers are removed. Sequentially, a third and fourth buffer layer of identical composition and structure as the first buffer layer are laminated to the first and second buffer layers, respectively, with flooding between each lamination and subsequent removal of the buffer layer support to form an optical waveguide device having a buried channel waveguide.

The resultant device is heated at 100°C for 60 minutes to achieve thermal stability.

The indexes of refraction of the film and layers in the laminated device were determined and are listed in Table III.

TABLE I

| FILM | |
|---|---|
| Ingredient | Weight % |
| Cellulose acetate butyrate, Eastman CAB 531-1 | 56.54 |
| 2-Phenoxyethyl acrylate (POEA) | 35.00 |
| Triethyleneglycol dicaprylate (TDC) | 5.00 |
| 2-Mercaptobenzoxazole (MBO) | 1.89 |
| o-Cl-HABI | 1.00 |
| Sensitizing dye (DEAW)[1] | 0.56 |
| 2,6-Di-tert-butyl-4-methylphenol (BHT) | 0.01 |

[1] 2,5-Bis([4-(diethylamino)-phenyl]methylene)cyclopentanone

TABLE II

| BUFFER LAYER [1] | |
|---|---|
| Ingredient | Weight % |
| CAB[1] 381-20 | 45.49 |
| POEA[2] | 20.00 |
| N-Vinylcarazole (NVC) | 15.00 |
| Ethoxylated bisphenol A diacrylate, Sartomer 349 | 15.00 |
| o-Cl-HABI[3] | 3.00 |
| 4-Methyl-4H-1,2,4-triazole-3-thiol (MMT) | 1.50 |
| BHT[4] | 0.01 |

[1] Cellulose acetate butyrate

[2] 2-Phenoxyethyl acrylate; CAS 48145-04-6

[3] 1,1′-Biimidazole, 2,2′-bis-O-chlorophenyl-4,4′, 5,5′-tetraphenyl; CAS 1707-68-2

[4] 2,6-Di-tert-butyl-4-methylphenol

TABLE III

| Layer or Film | REFRACTIVE INDEX |
|---|---|
| Active (non-exposed) Film | 1.535 |
| Waveguide Region of FIlm | 1.566 Avg. |
| Buffer Layer No. 1 | 1.545 |
| Buffer Layer No. 2 | 1.548 |
| Buffer Layer No. 3 | 1.545 |
| Buffer Layer No. 4 | 1.548 |

Those skilled in the art, having the benefit of the teachings of the present invention as hereinabove set forth, can effect numerous modifications thereto. These modifications are to be construed as being encompassed within the scope of the present invention as set forth in the appended claims.

## Claims

1. A substantially dry method of making an optical waveguide device with at least one buried channel waveguide in a laminated and hardened matrix, comprising the steps of:

   exposing to light at least a first region (7) of a substantially dry photohardenable film (1) having first (3) and second (4) surfaces, with a support (2) removably adhered to the first surface, so as to polymerize at least one monomer in the film and to change the refractive index of the region to form at least a first optical waveguide;

   laminating a first surface (15) of a first substantially dry photohardenable layer (14) to the film second surface, with a support (17) removably adhered to a second surface (16) of the first layer (14);

   removing the support (17) from the film first surface;

   laminating a first surface (19) of a second substantially dry photohardenable layer (18) to the film first surface, with a support (21) removably adhered to a second surface (20) of the second layer (18); and

   hardening the layers and film so as to form a hardened matrix, to substantially fix the indexes of refraction of the layers and the film, and to form at least one buried waveguide.

2. The method of Claim 1, wherein the hardening step comprises flooding the layers and film with light forming the hardened matrix.

3. The method of Claim 1, wherein the hardening step comprises heating the layers and film at a temperature in the range of about 50°C through 200°C for a duration of minutes.

4. The method of Claim 1, wherein the exposing step further comprises exposing the first region with actinic radiation through a mask.

5. The method of Claim 1, wherein the exposing step further comprises exposing the first region by using a focused laser light.

6. The method of Claim 1, wherein the exposing step further comprises exposing the first region to laser light through a mask.

7. The method of Claim 1, wherein the exposing step further comprises forming the waveguide having a substantially rectangular cross section for operating in a single mode fashion at a given wavelength.

8. The method of Claim 5, wherein the photohardenable film has a thickness which substantially defines one dimension of the rectangular cross section of the waveguide.

9. The method of Claim 1, further comprising the step of:

using a formulation of the photohardenable film having predetermined dimensions such that after the hardening step a localized refractive index increase occurs in the range of 0.001 through 0.40 measured at 546 nanometers wavelength by shearing interference microscopy.

10. The method of Claim 1, further comprising the step of:

using a formulation of the photohardenable film having predetermined dimensions such that after the hardening step the waveguide is transparent in the spectral region of 0.6 through 1.6 micrometers.

11. The method of Claim 8, wherein after the hardening step the waveguide is transparent at 1.3 micrometers for single mode operation.

12. The method of Claim 1, wherein after the hardening step the waveguide has a refractive index about 0.005 to 0.060 greater than hardened remaining regions of the film and about 0.001 to 0.025 greater than the hardened layers.

13. The method of Claim 1, wherein after the hardening step the maximum refractive index of the matrix except in and near the waveguide is in the range of 1.45 through 1.60 measured at 632 nanometers wavelength.

14. The method of Claim 1, wherein the matrix has a thickness which is selected from the group consisting of about 125, 180 and 200 micrometers.

15. The method of Claim 1, wherein the region substantially has a Y configuration.

16. The method of Claim 1, wherein the region has one end adapted to inlet or outlet light connected to a plurality of ends adapted to inlet or outlet light.

17. The method of Claim 1, further comprising the step of:

exposing at least a second region approaching and in part parallel to the first region to form at least a second waveguide such that the waveguides exhibit evanescent coupling of light injected into the first waveguide by gradually leaking or coupling the injected light into the second waveguide.

18. The method of Claim 1, further comprising the step of:

directing, before the hardening step, at least two coherent light beams to intersect in an area selected from the group consisting of at least part of the region, at least part of one of the layers near the region, and combinations thereof to provide a resultant light intensity that spatially varies in such a way as to produce a holographic diffraction grating comprising regions of varying refractive index for directing light.

19. The method of Claim 1, further comprising the step of:

flooding, between the exposing and first laminating steps, the film with light.

20. The method of Claim 1, further comprising the step of:

flooding, between the first laminating step and the removing step, the film and layer with light.

21. The method of Claim 1, further comprising the step of:

removing, after the flooding step, the support from at least one of the layer second surfaces.

22. The method of Claim 21, further comprising the step of:

stabilizing, after the second removing step, the hardened matrix by heating the matrix at a temperature in the range of about 50°C through 200°C for a duration in the range of about 30 minutes through 2 hours.

23. The method of Claim 1, further comprising, between the second laminating step and the hardening steps, the steps of:

removing the support from one of the layer second surfaces;

laminating a first surface of another substantially dry photohardenable layer on the one layer second surface, with a support removably adhered to a second surface of the another layer; and

repeating the second removing and the third laminating steps until a predetermined number of layers are in the matrix.

24. The method of Claim 23, further comprising the step of:

immediately before at least one of the second removing step and any repetition thereof, exposing to light at least a first region of one of the layers adhered to one of the supports to be removed in a subsequent step, polymerizing at least one monomer in the one layer and changing the refractive index to form at least another optical waveguide.

25. The method of Claim 24, wherein the at least another optical waveguide connects to the at least one waveguide in the film such that light traveling through one of the another waveguide and the film waveguide will travel through the other one.

26. The method of Claim 24, wherein a first of the another waveguides connects to a second of the another waveguides such that light traveling through the first another waveguide travels through the second another waveguide.

27. The method of Claim 24, further comprising:

flooding, between at least one of the exposing and removing steps, the film and the layers with light forming a photohardened matrix.

28. An optical waveguide device for use in integrated optical systems comprising:

a film (1) having first (3) and second (4) surfaces, the film having a first region (7) and remaining regions, the first region adapted to transmit light as an optical waveguide;

a first layer (14) having first (15) and second (16) surfaces, the first layer first surface laminated on the film first surface covering a first side of the waveguide; and

a second layer (18) having first (19) and second (20) surfaces, the second layer first surface laminated on the film second surface covering a second side of the waveguide,

characterized in that the film (1) is a photohardened film and the layers (14, 18) are photohardened layers.

29. The device as set forth in Claim 28, wherein the waveguide comprises a substantially rectangular cross section about 5 by 5.3 micrometers generally orthogonal to the film.

30. The device as set forth in Claim 28, wherein the film is about 5.5 micrometers thick.

31. The device as set forth in Claim 28, wherein a localized refractive index increase in the range of 0.001 through 0.40 exists between the waveguide and the film remaining regions measured at 546 nanometers wavelength by shearing interference microscopy.

32. The device as set forth in Claim 28, wherein the waveguide is effectively transparent in the spectral region of 0.6 to 1.6 micrometers.

33. The device as set forth in Claim 28, wherein the waveguide is transparent at 1.3 micrometers for single mode operation.

34. The device as set forth in Claim 28, wherein the film remaining regions, the first layer and the second layer are substantially homogenous in composition and refractive index except near the waveguide.

35. The device as set forth in Claim 28, wherein the waveguide has a refractive index of about 0.005 to 0.060 greater than the remaining regions and about 0.001 to 0.025 greater than the layers.

36. The device as set forth in Claim 28, wherein the maximum refractive index of the film remaining regions, the first layer and the second layer except near the region is in the range of 1.45 through 1.60 measured at 632 nanometers wavelength.

37. The device as set forth in Claim 28, wherein the thickness of the film the first layer and the second layer is selected from the group consisting of about 125, 180 and 200 micrometers.

38. The device as set forth in Claim 28, wherein the waveguide substantially has a Y configuration.

39. The device as set forth in Claim 28, wherein the waveguide has one end adapted to inlet or outlet light connected to a plurality of ends adapted to inlet or outlet light.

40. The device as set forth in Claim 28, further comprising at least a second waveguide in part parallel to the first waveguide such that the waveguides exhibit evanescent coupling of light injected into the first waveguide by gradually leaking or coupling the injected light into the second waveguide.

41. The device as set forth in Claim 28, further comprising a holographic diffraction grating comprising areas of varying refractive indexes in a space selected from the group consisting of at least part of the first region, at least part of one of the layers near the region, and combinations thereof to direct light.

42. The device as set forth in Claim 28, further comprising:

   a support removably adhered to the first layer second surface; and

   a support removably adhered to the second layer second surface.

43. The device as set forth in Claim 28, wherein:
   the photohardened film is produced from a film which comprises

   (a) a solvent soluble binder,

   (b) at least one liquid ethylenically unsaturated monomer capable of addition polymerization, and

   (c) a photoinitiator system activatable by the actinic radiation.

44. The device as set forth in Claim 28, wherein:
   at least one of the photohardened layers is produced from a layer which comprises

   (a) a solvent soluble binder,

   (b) at least one liquid ethylenically unsaturated monomer capable of addition polymerization, and

   (c) a photoinitiator system activatable by the actinic radiation.

45. A system for transmitting light comprising the optical waveguide device as set forth in Claim 28 and a single mode optical fiber coupled to the device with optical axes in alignment.

46. An optical waveguide element for use in forming optical devices comprising:

   a film (1) having first (3) and second (4) surfaces, the film having a first photohardened region (7) adapted to transmit light as an optical waveguide and substantially dry photohardenable remaining regions; and

   a support (2) removably adhered to the first surface.

47. The element as set forth in Claim 46, further comprising:

   a first substantially dry photohardenable layer having first and second surfaces, the first layer first surface laminated to the film second surface; and

   a support removably adhered to the first layer second surface.

48. The element as set forth in Claim 46, wherein:

the film is produced from a film which comprises

(a) a solvent soluble binder,

(b) at least one liquid ethylenically unsaturated monomer capable of addition polymerization, and

(c) a photoinitiator system activatable by the actinic radiation.

49. An optical waveguide element for use in forming optical waveguide devices comprising:

a photohardened film (1) having first (3) and second (4) substantially flat surfaces, the film having a first region and remaining regions, the first region (7) adapted to transmit light as an optical waveguide; and

a support (2) removably adhered to the first surface.

50. The element as set forth in Claim 49, wherein:
the photohardened film is produced from a film which comprises

(a) a solvent binder,

(b) at least one liquid ethylenically unsaturated monomer capable of addition polymerization, and

(c) a photoinitiator system activatable by the actinic radiation.

**Patentansprüche**

1. Im wesentlichen trockenes Verfahren zur Herstellung einer optischen Wellenleiter-Vorrichtung mit wenigstens einem Wellenleiter in Form eines verdeckten Kanals in einer laminierten und gehärteten Matrix, mit folgenden Schritten:

Belichten wenigstens eines ersten Bereichs (7) einer im wesentlichen trockenen, photohärtbaren Folie (1), die erste (3) und zweite (4) Oberflächen aufweist, wobei ein Träger (2) entfernbar an der ersten Oberfläche haftet, derart, daß wenigstens ein Monomer in der Folie polymerisiert und daß sich der Brechungsindex des Bereichs ändert, um wenigstens einen optischen Wellenleiter zu bilden;

Laminieren einer ersten Oberfläche (15) einer ersten im wesentlichen trockenen, photohärtbaren Lage (14) auf die zweite Oberfläche der Folie, wobei ein Träger (17) entfernbar an einer zweiten Oberfläche (16) der ersten Lage (14) haftet;

Entfernen des Trägers (17) von der ersten Oberfläche der Folie;

Laminieren einer ersten Oberfläche (19) einer zweiten im wesentlichen trockenen photohärtbaren Lage (18) auf die erste Oberfläche der Folie, wobei ein Träger (21) entfernbar an einer zweiten Oberfläche (20) der zweiten Lage (18) haftet, und

Härten der Lagen und der Folie derart, daß eine gehärtete Matrix hergestellt wird, daß die Brechungsindizes der Lagen und der Folie im wesentlichen fixiert werden und daß wenigstens ein verdeckter Wellenleiter gebildet wird.

2. Verfahren nach Anspruch 1, wobei der Härtungsschritt umfaßt, daß die Lagen und die Folie mit Flutlicht bestrahlt werden, das die gehärtete Matrix bildet.

3. Verfahren nach Anspruch 1, wobei der Härtungsschritt umfaßt, daß die Lagen und die Folie auf eine Temperatur im Bereich von etwa 50°C bis 200°C für die Dauer von Minuten erwärmt wird.

4. Verfahren nach Anspruch 1, wobei der Belichtungsschritt ferner umfaßt das Belichten des ersten Bereichs mit aktinischer Strahlung durch eine Maske hindurch.

**5.** Verfahren nach Anspruch 1, wobei der Belichtungsschritt ferner umfaßt das Belichten des ersten Bereichs unter Verwendung eines fokussierten Laserlichts.

**6.** Verfahren nach Anspruch 1, wobei der Belichtungsschritt ferner umfaßt das Belichten des ersten Bereichs mit Laserlicht durch eine Maske hindurch.

**7.** Verfahren nach Anspruch 1, wobei der Belichtungsschritt ferner umfaßt das Herstellen des Wellenleiters mit einem im wesentlichen rechteckförmigen Querschnitt zum Einmodenbetrieb bei einer bestimmten Wellenlänge.

**8.** Verfahren nach Anspruch 5, wobei die photohärtbare Folie eine Dicke hat, die im wesentlichen eine Abmessung des rechteckförmigen Querschnitts des Wellenleiters definiert.

**9.** Verfahren nach Anspruch 1, mit dem weiteren Schritt:
Verwendung einer Formulierung der photohärtbaren Folie mit vorgegebenen Abmessungen derart, daß nach dem Härtungsschritt eine stellenweise Erhöhung des Brechungsindexes im Bereich von 0,001 bis 0,40 auftritt, gemessen bei 546 nm Wellenlänge mittels eines Scheren-Interferenz-Mikroskops.

**10.** Verfahren nach Anspruch 1, mit dem weiteren Schritt:
Verwenden einer Formulierung der photohärtbaren Folie, die vorgegebene Abmessungen aufweist, derart, daß nach dem Härtungsschritt der Wellenleiter im Spektralbereich von 0,6 bis 1,6 μm transparent ist.

**11.** Verfahren nach Anspruch 8, wobei der Wellenleiter nach dem Härtungsschritt bei 1,3 μm für Einmodenbetrieb transparent ist.

**12.** Verfahren nach Anspruch 1, wobei der Wellenleiter nach dem Härtungsschritt einen Brechungsindex von etwa 0,005 bis 0,060 über dem der gehärteten übrigen Bereiche der Folie und etwa 0,001 bis 0,025 über dem der gehärteten Lagen aufweist.

**13.** Verfahren nach Anspruch 1, wobei nach dem Härtungsschritt der maximale Brechungsindex der Matrix, ausgenommen in und nahe dem Wellenleiter, im Bereich von 1,45 bis 1,60 gemessen bei 632 nm Wellenlänge liegt.

**14.** Verfahren nach Anspruch 1, wobei die Matrix eine Dicke von etwa 125, 180 oder 200 μm aufweist.

**15.** Verfahren nach Anspruch 1, wobei der Bereich im wesentlichen eine Y-Form hat.

**16.** Verfahren nach Anspruch 1, wobei der Bereich ein Ende hat, das für den Eintritt oder den Austritt von Licht vorgesehen ist, verbunden mit einer Mehrzahl von Enden, die für den Eintritt oder Austritt von Licht vorgesehen sind.

**17.** Verfahren nach Anspruch 1 mit dem weiteren Schritt:
Belichten wenigstens eines zweiten Bereichs in der Nähe und teilweise parallel zu dem ersten Bereich, um wenigstens einen zweiten Wellenleiter herzustellen, derart, daß die Wellenleiter eine dämpfende Kopplung von in den ersten Wellenleiter eingeleitetem Licht zeigen, indem das eingeleitete Licht schrittweise in den zweiten Wellenleiter leckt oder koppelt.

**18.** Verfahren nach Anspruch 1 mit dem weiteren Schritt:
Lenken von wenigstens zwei kohärenten Lichtstrahlen vor dem Härtungsschritt, um sie in einem Flächenbereich zum Schnitt zu bringen, der wenigstens Teil des Bereichs, wenigstens Teil einer der Lagen in der Nähe des Bereichs oder Kombinationen davon ist, um eine resultierende Lichtintensität zu erzeugen, die sich räumlich derart ändert, daß ein holographisches Beugungsgitter zum Lenken von Licht erzeugt wird, wobei das Gitter Bereiche unterschiedlicher Werte des Brechungsindexes aufweist.

**19.** Verfahren nach Anspruch 1 mit dem weiteren Schritt:
Belichten der Folie mit Flutlicht zwischen dem Belichtungsschritt und dem ersten Laminierungsschritt.

**20.** Verfahren nach Anspruch 1 mit dem weiteren Schritt:
Belichten der Folie und Lage mit Flutlicht zwischen dem ersten Laminierungsschritt und dem Schritt des Entfernens des Trägers.

EP 0 324 493 B1

**21.** Verfahren nach Anspruch 1 mit dem weiteren Schritt:
Entfernen des Trägers von wenigstens einer der zweiten Oberflächen der Lage nach dem Schritt des Belichtens mit Flutlicht.

**22.** Verfahren nach Anspruch 1 mit dem weiteren Schritt:
Stabilisieren der gehärteten Matrix durch Erwärmen der Matrix auf eine Temperatur im Bereich von etwa 50°C bis 200°C für eine Dauer im Bereich von etwa 30 Minuten bis 2 Stunden nach dem zweiten Träger-Entfernen-Schritt.

**23.** Verfahren nach Anspruch 1 mit den weiteren Schritten zwischen dem zweiten Laminierungsschritt und dem Härtungsschritt:

Entfernen des Trägers von einer der zweiten Oberflächen der Lage;

Laminieren einer ersten Oberfläche einer weiteren im wesentlichen trockenen photohärtbaren Lage auf die zweite Oberfläche der einen Lage, wobei ein Träger entfernbar an einer zweiten Oberfläche der weiteren Lage haftet, und

Wiederholen des zweiten Träger-Entfernen-Schritts und des dritten Laminierungsschritts bis eine vorgegebene Anzahl von Lagen in der Matrix vorhanden sind.

**24.** Verfahren nach Anspruch 23 mit dem weiteren Schritt:
unmittelbar vor wenigstens einem der zweiten Träger-Entfernen-Schritte und irgendeiner Wiederholung davon, Belichten wenigstens eines ersten Bereichs einer der Lagen, die an einem der Träger, die in einem nachfolgenden Schritt zu entfernen sind, haftet, wobei wenigstens ein Monomer in der einen Lage polymerisiert und sich der Brechungsindex zur Bildung wenigstens eines weiteren optischen Wellenleiters ändert.

**25.** Verfahren nach Anspruch 24, wobei der wenigstens eine weitere optische Wellenleiter in Verbindung steht mit dem wenigstens einen Wellenleiter in der Folie, so daß Licht, das durch den weiteren Wellenleiter oder den Folienwellenleiter geht, durch den anderen gehen wird.

**26.** Verfahren nach Anspruch 24, wobei ein erster der weiteren Wellenleiter in Verbindung steht mit einem zweiten der weiteren Wellenleiter derart, daß Licht, das durch den ersten weiteren Wellenleiter geht, durch den zweiten weiteren Wellenleiter geht.

**27.** Verfahren nach Anspruch 24 mit dem weiteren Schritt:
Belichten der Folie und der Lagen mit Flutlicht zur Bildung einer photogehärteten Matrix zwischen wenigstens einem der Belichtungsschritte und der Träger-Entfernen-Schritte.

**28.** Optische Wellenleitervorrichtung zur Verwendung in integrierten optischen Systemen mit:

einer Folie (1) mit ersten (3) und zweiten (4) Oberflächen, wobei die Folie einen ersten Bereich (7) und restliche Bereiche aufweist und der erste Bereich zur Weiterleitung von Licht als ein optischer Wellenleiter vorgesehen ist;

einer ersten Lage (14) mit ersten (15) und zweiten (16) Oberflächen, wobei die erste Oberfläche der ersten Lage auf die erste Oberfläche der Folie laminiert ist und eine erste Seite des Wellenleiters abdeckt; und

einer zweiten Lage (18) mit ersten (19) und zweiten (20) Oberflächen, wobei die erste Oberfläche der zweiten Lage auf die zweite Oberfläche der Folie laminiert ist und eine zweite Seite des Wellenleiters abdeckt,

dadurch gekennzeichnet, daß die Folie (1) eine photogehärtete Folie ist und die Lagen (14, 18) photogehärtete Lagen sind.

**29.** Vorrichtung nach Anspruch 28, wobei der Wellenleiter einen im wesentlichen rechteckförmigen Querschnitt von etwa 5 x 5,3 µm insgesamt rechtwinklig zu der Folie hat.

**30.** Vorrichtung nach Anspruch 28, wobei die Folie etwa 5,5 µm dick ist.

16

**31.** Vorrichtung nach Anspruch 28, wobei eine stellenweise Erhöhung des Brechungsindexes im Bereich von 0,001 bis 0,40 zwischen dem Wellenleiter und den restlichen Bereichen der Folie vorhanden ist, gemessen bei 456 nm Wellenlänge mittels eines Scheren-Interferenz-Mikroskops.

**32.** Vorrichtung nach Anspruch 28, wobei der Wellenleiter im Spektralbereich von 0,6 bis 1,6 µm effektiv transparent ist.

**33.** Vorrichtung nach Anspruch 28, wobei der Wellenleiter bei 1,3 µm für Einmodenbetrieb transparent ist.

**34.** Vorrichtung nach Anspruch 28, wobei die restlichen Bereiche der Folie, die erste Lage und die zweite Lage in der Zusammensetzung und im Brechungsindex mit Ausnahme in der Nähe des Wellenleiters im wesentlichen homogen sind.

**35.** Vorrichtung nach Anspruch 28, wobei der Wellenleiter einen Brechungsindex von etwa 0,005 bis 0,060 über dem der restlichen Bereiche und etwa 0,001 bis 0,025 über dem der Lagen hat.

**36.** Vorrichtung nach Anspruch 28, wobei der maximale Brechungsindex der restlichen Bereiche der Folie, der ersten Lage und der zweiten Lage ausgenommen in der Nähe des Bereichs in dem Größenbereich von 1,45 bis 1,60 gemessen bei 632 nm Wellenlänge liegt.

**37.** Vorrichtung nach Anspruch 28, wobei die Dicke der Folie, der ersten Lage und der zweiten Lage etwa 125, 180 oder 200 µm beträgt.

**38.** Vorrichtung nach Anspruch 28, wobei der Wellenleiter im wesentlichen eine Y-Form hat.

**39.** Vorrichtung nach Anspruch 28, wobei der Wellenleiter ein Ende hat, das zum Eingeben oder Ausgeben von Licht vorgesehen ist, verbunden mit einer Mehrzahl von Enden, die zum Eingeben oder Ausgeben von Licht vorgesehen sind.

**40.** Vorrichtung nach Anspruch 28 mit wenigstens einem zweiten Wellenleiter teilweise parallel zu dem ersten Wellenleiter derart, daß die Wellenleiter dämpfende Kopplung von Licht zeigen, das in den ersten Wellenleiter eingegeben wurde, indem das eingegebene Licht schrittweise in den zweiten Wellenleiter leckt oder einkoppelt.

**41.** Vorrichtung nach Anspruch 28 mit ferner einem holographischen Beugungsgitter, das Stellen unterschiedlicher Brechungsindizes in einem Raum aufweist, der wenigstens Teil des ersten Bereichs, wenigstens Teil einer der Lagen in der Nähe des Bereichs oder Kombinationen davon ist, um Licht zu lenken.

**42.** Vorrichtung nach Anspruch 28 mit ferner:

einem Träger, der entfernbar an der zweiten Oberfläche der ersten Lage haftet, und

einem Träger, der entfernbar an der zweiten Oberfläche der zweiten Lage haftet.

**43.** Vorrichtung nach Anspruch 28, wobei die photohärtbare Folie aus einer Folie hergestellt ist, die folgendes enthält:

(a) ein in Lösungsmittel lösliches Bindemittel;

(b) wenigstens ein flüssiges ethylenisch ungesättigtes Monomer, das zur Additionspolymerisation in der Lage ist, und

(c) ein Photoinitiatorsystem, das durch aktinische Strahlung aktivierbar ist.

**44.** Vorrichtung nach Anspruch 28, wobei wenigstens eine der photogeärteten Lagen aus einer Lage hergestellt ist, die folgendes umfaßt:

(a) ein in Lösungsmittel lösliches Bindemittel,

(b) wenigstens ein flüssiges ehtylenisch ungesättigtes Monomer, das zur Additionspolymerisation in der Lage ist, und

(c) ein Photoinitiatorsystem, das durch aktinische Strahlung aktivierbar ist.

45. System zum Weiterleiten von Licht mit einer optischen Wellenleitervorrichtung nach Anspruch 28 und einer optischen Einmoden-Faser, die mit der Vorrichtung gekoppelt ist, wobei die optischen Achsen fluchten.

46. Optisches Wellenleiterelement zur Verwendung bei der Herstellung optischer Vorrichtungen, mit:

einer Folie (1) mit ersten (3) und zweiten (4) Oberflächen, wobei die Folie einen ersten photogehärteten Bereich (7) aufweist, der zur Weiterleitung von Licht als ein optischer Wellenleiter vorgesehen ist, sowie im wesentlichen trockene photohärtbare restliche Bereich, und

einen Träger (2), der entfernbar an der ersten Oberfläche haftet.

47. Element nach Anspruch 46, ferner mit:

einer ersten im wesentlichen trockenen photohärtbaren Lage mit ersten und zweiten Oberflächen, wobei die erste Oberfläche der ersten Lage auf die zweite Oberfläche der Folie laminiert ist, und

einem Träger, der entfernbar an der zweiten Oberfläche der ersten Lage haftet.

48. Element nach Anspruch 46, wobei die Folie aus einer Folie hergestellt ist, die folgendes enthält:

(a) ein in Lösungsmittel lösliches Bindemittel,

(b) wenigstens ein flüssiges ehtylenisch ungesättigtes Monomer, das zur Additionspolymerisation in der Lage ist, und

(c) ein Photoinitiatorsystem, das durch aktinische Strahlung aktivierbar ist.

49. Optisches Wellenleiterelement zur Verwendung bei der Herstellung optischer Wellenleitervorrichtungen, mit:

einer photohärtbaren Folie (1) mit ersten (3) und zweiten (4) im wesentlichen ebenen Oberflächen, wobei die Folie einen ersten Bereich und restliche Bereiche aufweist und der erste Bereich (7) zur Weiterleitung von Licht als ein optischer Wellenleiter eingerichtet ist; und

einem Träger (2), der entfernbar an der ersten Oberfläche haftet.

50. Das Element von Anspruch 49, wobei die photohärtbare Folie aus einer Folie hergestellt ist, die folgendes enthält:

(a) ein in Lösungsmittel lösliches Bindemittel,

(b) wenigstens ein flüssiges ehtylenisch ungesättigtes Monomer, das zur Additionspolymerisation in der Lage ist, und

(c) ein Photoinitiatorsystem, das durch aktinische Strahlung aktivierbar ist.

**Revendications**

1. Un procédé par voie sensiblement sèche pour la réalisation d'un dispositif de guide d'onde optique ayant au moins un canal de guide d'onde noyé dans une matrice stratifiée durcie comprenant les phases suivantes:

- exposition à la lumière d'au moins une première région (7) d'un film photodurcissable sensiblement sec (1) comportant une première et une seconde surfaces (3, 4), respectivement, avec un support (2) fixé de manière amovible à la première surface, de façon à polymériser au moins un monomère dans ce film et à modifier l'indice de réfraction de la région pour constituer au moins un premier guide d'onde optique;
- stratification d'une première surface (15) d'une première couche (14) photodurcissable sensiblement sèche à la seconde surface du film, avec un support (17) fixé de manière amovible à une seconde surface (16) de la première couche (14);

- séparation du support (17) de la première surface du film;

- stratification d'une première surface (19) d'une seconde couche (18) photodurcissable sensiblement sèche à la première surface du film avec un support (21) fixé de manière amovible à une seconde surface (20) de la seconde couche (18); et

- durcissement des couches et films de façon à ménager une matrice durcie, à fixer sensiblement les indices de réfraction des couches et du film et à former au moins un guide d'onde noyé.

2. Le procédé de la revendication 1, dans lequel la phase de durcissement comprend l'illumination des couches et du film à la lumière pour former la matrice durcie.

3. Le procédé de la revendication 1, dans lequel la phase de durcissement comprend le chauffage des couches et du film à une température comprise entre environ 50°C à 200°C pendant une durée de quelques minutes.

4. Le procédé de la revendication 1, dans lequel la phase d'exposition comprend en outre l'exposition de la première région à une radiation actinique à travers un masque.

5. Le procédé de la revendication 1, dans lequel la phase d'exposition comprend en outre l'exposition de la première région en utilisant une lumière laser focalisée.

6. Le procédé de la revendication 1, dans lequel la phase d'exposition comprend en outre l'exposition de la première région à une lumière laser à travers un masque.

7. Le procédé de la revendication 1, dans lequel la phase d'exposition comprend en outre la formation du guide d'onde ayant une section transversale sensiblement rectangulaire pour fonctionner en mode simple avec une longueur d'onde donnée.

8. Le procédé de la revendication 5, dans lequel le film photodurcissable a une épaisseur qui définit sensiblement l'une des dimensions de la section transversale rectangulaire du guide d'onde.

9. Le procédé de la revendication 1, comprenant en outre les phases de:

- utilisation d'une formulation du film photodurcissable ayant des dimensions prédéterminées telles qu'après la phase de durcissement, il se produit un accroissement de l'indice de réfraction focalisé dans la gamme de 0,001 à 0,40, mesuré sous une longueur d'onde de 546 nm en utilisant un microscope à interférence par cisaillement.

10. Le procédé de la revendication 1, comprenant en outre les phases de:

- utilisation d'une formulation du film photodurcissable ayant des dimensions prédéterminées telles qu'après la phase de durcissement, le guide d'onde soit transparent dans la région spectrale de 0,6 à 1,6 micromètre.

11. Le procédé de la revendication 8, dans lequel, après la phase de durcissement, le guide d'onde est transparent 1,3 micromètre pour un fonctionnement en mode simple.

12. Le procédé de la revendication 1, dans lequel, après la phase de durcissement, le guide d'onde a un indice de réfraction d'environ 0,005 à 0,060 supérieur aux régions restantes du film durci et d'environ 0,001 à 0,025 supérieur aux couches durcies.

13. Le procédé de la revendication 1, dans lequel, après la phase de durcissement, l'indice de réfraction maximum de la matrice, sauf dans le guide d'onde et proche de celui-ci, est dans la gamme de 1,45 à 1,60, mesuré à une longueur d'onde de 632 nm.

14. Le procédé de la revendication 1, dans lequel la matrice a une épaisseur qui est choisie dans le groupe consistant en environ 125, 180 et 200 micromètres.

15. Le procédé de la revendication 1, dans lequel la région a sensiblement une configuration en Y.

**16.** Le procédé de la revendication 1, dans lequel la région a une extrémité adaptée à l'entrée ou à la sortie de lumière reliée à une pluralité d'extrémités adaptées à l'entrée ou la sortie de lumière.

**17.** Le procédé de la revendication 1, comprenant en outre la phase:

exposition d'au moins une seconde région proche de la première région et en partie parallèle à celle-ci pour constituer au moins un second guide d'onde tel que ces guides d'ondes présentent un couplage évanescent à la lumière injectée dans le premier guide d'onde en laissant passer ou en accouplant graduellement la lumière injectée dans le second guide d'onde.

**18.** Le procédé de la revendication 1, comprenant en outre la phase de:

- guidage, avant la phase de durcissement, d'au moins deux faisceaux de lumière cohérente, de manière qu'ils se couplent dans une zone choisie dans le groupe consistant en au moins une partie de la région, au moins une partie de l'une des couches proches de la région et des combinaisons de celles-ci, pour ménager une intensité de lumière résultante qui varie spatialement de matière à ménager un réseau de diffraction holographique comprenant des régions d'indice de réfraction variable pour la lumière ainsi guidée.

**19.** Le procédé de la revendication 1, comprenant en outre la phase de:

- illumination, entre les phases d'exposition et de première stratification. du film par de la lumière.

**20.** Le procédé de la revendication 1, comprenant en outre la phase de:

- illumination entre la première phase de stratification et la phase d'enlèvement du film et de la couche avec de la lumière.

**21.** Le procédé de la revendication 1, comprenant en outre la phase de:

- séparation après la phase d'illumination du support d'au moins une des secondes surfaces de la couche.

**22.** Le procédé de la revendication 21, comprenant en outre la phase de:

- stabilisation après la seconde phase de séparation de la matrice durcie par chauffage de cette matrice à une température comprise dans la gamme d'environ 50°C à 200°C pendant une durée comprise dans la gamme allant d'environ 30 minutes à 2 heures.

**23.** Le procédé de la revendication 1, comprenant en outre, entre la seconde phase de stratification et les phases de durcissement, les phases consistant à:

- séparer un support de l'une des secondes surfaces de la couche;
- stratifier une première surface d'une autre couche photodurcissable sensiblement sèche sur cette couche de la seconde surface, un support étant fixé de manière amovible à la seconde surface d'une autre couche; et
- répétition des phases de seconde séparation et de troisième stratification jusqu'à ce qu'un nombre prédéterminé de couches se trouve dans la matrice.

**24.** Le procédé de la revendication 23, comprenant en outre la phase consistant à:

- immédiatement avant au moins l'une des secondes phases de séparation et toutes répétitions de celle-ci, l'exposition à la lumière d'au moins une première région de l'une des couches fixée à l'un des supports pour en être séparée dans une phase ultérieure, la polymérisation d'au moins un monomère dans cette dite couche et la modification d'un indice de réfraction pour former au moins un autre guide d'onde optique.

**25.** Le procédé de la revendication 24, dans lequel ledit autre guide d'onde optique relie ce dit guide d'onde dans le film de manière telle que la lumière traverse l'un de cet autre guide d'onde et que le guide d'onde du film traverse ledit autre.

**26.** Le procédé de la revendication 24, dans lequel un premier des autres guides d'onde relie un second d'un autre guide d'onde de manière telle que la lumière traversant ledit premier autre guide d'onde traverse ledit second autre guide d'onde.

**27.** Le procédé de la revendication 24, comprenant en outre l'illumination entre au moins une des phases d'exposition et de séparation, du film et des couches au moyen de lumière, de façon former une matrice photodurcie.

**28.** Un dispositif de guide d'onde optique destiné à être utilisé dans des systèmes optiques intégrés comprenant:

- un film (1) ayant une première et une seconde surface (3, 4) respectivement, ce film comprenant une première région (7) et des régions restantes, la première région étant adaptée à transmettre la lumière sous la forme d'un guide d'onde optique;
- une première couche (14) ayant une première surface et une seconde surface (15, 16) respectivement, la première couche de la première surface étant stratifiée sur la première surface du film pour couvrir une première face du guide d'onde; et
- une seconde couche (18) ayant une première et une seconde surfaces (19 et 20) respectivement, la première surface de la seconde couche étant stratifiée sur la seconde surface du film pour couvrir une seconde face du guide d'onde, caractérisée en ce que le film (1) est un film photodurci et en ce que les couches (14, 18) sont des couches photodurcies.

**29.** Le dispositif tel que décrit dans la revendication 28, dans lequel le guide d'onde comprend une section transversale sensiblement rectangulaire d'environ 5 sur 5,3 micromètres, généralement orthogonale au film.

**30.** Le dispositif tel que décrit dans la revendication 28, dans lequel le film a une épaisseur d'environ 5,5 micromètres.

**31.** Le dispositif tel que décrit dans la revendication 28, dans lequel un accroissement de l'indice de réfraction localisé dans la gamme de 0,001 à 0,40 existe entre le guide d'onde et les régions restantes du film mesuré avec une longueur d'onde de 546 nanomètres par microscopie interférentielle par cisaillement.

**32.** Le dispositif tel que décrit dans la revendication 28, dans lequel le guide d'onde est réellement transparent dans la région spectrale de 0,6 à 1,6 micromètre.

**33.** Le dispositif tel que décrit dans la revendication 28, dans lequel le guide d'onde est transparent à 1,3 micromètre pour un mode de fonctionnement simple.

**34.** Le dispositif tel que décrit dans la revendication 28, dans lequel les régions restantes du film, la première couche et la seconde couche sont sensiblement homogènes en composition et en indice de réfraction, sauf à proximité du guide d'onde.

**35.** Le dispositif tel que décrit dans la revendication 28, dans lequel le guide d'onde a un indice de réfraction d'environ 0,005 à 0,060 supérieur aux régions restantes et d'environ 0,001 à 0,025 supérieur aux couches.

**36.** Le dispositif tel que décrit dans la revendication 28, dans lequel l'indice de réfraction maximum des régions restantes du film, de la première couche et de la seconde couche, sauf à proximité de la région, est compris dans la gamme de 1,45 à 1,60, mesuré avec une longueur d'onde de 632 nanomètres.

**37.** Le dispositif tel que décrit dans la revendication 28, dans lequel l'épaisseur du film, la première couche et la seconde couche sont choisis dans le groupe consistant en environ 125, 180 et 200 micromètres.

**38.** Le dispositif tel que décrit dans la revendication 28, dans lequel le guide d'onde a sensiblement une conformation en Y.

**39.** Le dispositif tel que décrit dans la revendication 28, dans lequel le guide d'onde a une extrémité adaptée à une lumière d'entrée et de sortie reliée à une pluralité d'extrémités adaptées à l'entrée et à la sortie de la lumière.

**40.** Le dispositif tel que décrit dans la revendication 28, comprenant en outre au moins un second guide d'onde parallèle en partie au premier guide d'onde de manière que ces guides d'onde présentent un couplage évanescent de la lumière injectée dans le premier guide d'onde par passage ou couplage graduel de la lumière injectée dans le second guide d'onde.

**41.** Le dispositif tel que décrit dans la revendication 28, comprenant en outre un réseau de diffraction holographique comprenant des zones d'indices de réfraction variables dans un espace choisi dans le groupe consistant en au moins une partie de la première région, au moins une partie de l'une des couches proches de cette région et des combinaisons de celles-ci pour diriger la lumière.

**42.** Le dispositif tel que décrit dans la revendication 28, comprenant en outre:

- un support fixé de manière amovible à la seconde surface de la première couche; et
- un support fixé de manière amovible à la seconde surface de la seconde couche.

**43.** Le dispositif tel que décrit dans la revendication 28, dans lequel le film photodurci est réalisé à partir d'un film qui comprend:

(a) un liant soluble par solvant;
(b) au moins un monomère liquide éthyléniquement non saturé capable de polymérisation d'addition; et
(c) un système photoinitiateur activable par la radiation actinique.

**44.** Le dispositif tel que décrit dans la revendication 28, dans lequel au moins une des couches photodurcies est réalisée à partir d'une couche qui comprend:

(a) un liant soluble par solvant;
(b) au moins un monomère liquide éthyléniquement non saturé capable de polymérisation d'addition; et
(c) un système photoinitiateur activable par la radiation actinique.

**45.** Un système pour la transmission de lumière comprenant le dispositif de guide d'onde optique tel que décrit dans la revendication 28, et une fibre optique fonctionnant en mode simple couplée au dispositif, les axes optiques étant alignés.

**46.** Un élément de guide d'onde optique destiné à être utilisé pour la réalisation de dispositifs optiques, comprenant:

- un film (1) comportant une première et une seconde surfaces (3, 4) respectivement, ce film ayant une première région photodurcie (7) adaptée à transmettre la lumière comme un guide d'onde optique, et des régions restantes photodurcissables sensiblement sèches; et
- un support (2) fixé de manière amovible à la première surface.

**47.** L'élément comme décrit dans la revendication 46, comprenant en outre:

- une première couche photodurcissable sensiblement sèche ayant une première et une seconde surfaces, la première surface de cette première couche étant stratifiée sur la seconde surface du film; et
- un support fixé de manière amovible à la seconde surface de la première couche.

**48.** L'élément comme décrit dans la revendication 46, dans lequel le film est réalisé à partir d'un film qui comprend:

(a) un liant soluble par solvant;
(b) au moins un monomère liquide éthyléniquement non saturé capable de polymérisation d'addition; et
(c) un système photoinitiateur activable par la radiation actinique.

**49.** Un dispositif de guide d'onde optique destiné à être utilisé pour la réalisation de dispositifs de guides d'onde optique comprenant:

- un film photodurci (1) comprenant une première et une seconde surfaces sensiblement planes (3, 4) respectivement, ce film ayant une première région et des régions restantes, la première région (7) étant adaptée à transmettre la lumière comme un guide d'onde optique; et
- un support (2) fixé de manière amovible à la première surface.

**50.** Un élément comme décrit dans la revendication 49, dans lequel le film photodurci est réalisé à partir d'un film qui comprend:

(a) un liant soluble par solvant;

(b) au moins un monomère liquide éthyléniquement non saturé capable de polymérisation d'addition; et

(c) un système photoinitiateur activable par la radiation actinique.

FIG. 1

FIG. 2a

TRANSLATIONAL
MECHANISM

FIG. 2b

FIG. 2c

FIG. 3

FIG. 4

FIG. 5

FIG. 6

FIG. 7

FIG. 8

FIG. 9

HEAT

7

17

14

1

18

21

FIG. 10

7

14

1

18

FIG. 11

FIG. 12

14

1

7

18

24

23

22

25

31

EP 0 324 493 B1

FIG. 13a

FIG. 13b

EP 0 324 493 B1

FIG. 14